# DEMANDE DE BREVET EUROPEEN

(11) **EP 0 851 582 A1**
(43) Date de publication de la demande: **01.07.1998**
(21) Numéro de dépôt: 97204003.4
(22) Date de dépôt: 18.12.1997
(51) Int. Cl.: H03K 3/2885

(54) **Bascule du genre D.**

(30) Priorité: 31.12.1996 FR 9616263
(71) Demandeur: Philips Electronics N.V., 5621 BA Eindhoven (NL)
(72) Inventeur: Ridgers, Timothy, 75008 Paris (FR)
(74) Mandataire: Caron, Jean

(57) **Abrégé**

Cette bascule, réalisée en technique dite ECL ou CML, comporte une sortie interne de signal logique en mode symétrique, elle est munie de deux transistors suiveurs pour délivrer les deux composantes du signal de sortie à partir de la sortie interne, et ces deux transistors suiveurs sont chacun l'un des transistors d'une paire dite de forçage dont la base de l'autre transistor est reliée à une entrée de signal de test.

Applications : circuits intégrés, télévision, radio, radio-téléphonie.

## Description

La présente invention concerne une bascule du genre D réalisable dans une technique dite ECL ou CML, comportant une première paire de transistors constituant une première demi-bascule, délivrant un premier signal logique sur un premier couple de connexions logiques, une seconde paire de transistors constituant une seconde demi-bascule, délivrant un second signal logique sur un second couple de connexions logiques, les deux paires étant couplées entre elles pour constituer ensemble une bascule complète, la seconde paire de connexions logiques constituant une sortie interne de signal logique de la bascule, en mode symétrique.

Elle concerne aussi un circuit de pompe de charge, ainsi qu'un circuit intégré.

Pour mémoire : les acronymes ECL et CML signifient respectivement, en langue anglaise, "Emitter Coupled Logic" et "Current Mode Logic". Lorsqu'une "paire de transistors" est mentionnée, il s'agit toujours de deux transistors dont les émetteurs sont reliés ensemble à une source de courant.

Lorsqu'une bascule est utilisée dans un circuit complexe, il est partois difficile de vérifier le fonctionnement de ce circuit dans tous les cas possibles.

L'invention a entre autres pour but de procurer une bascule qui, sans que sa structure soit trop compliquée de ce fait, facilite le test d'un circuit complexe dans lequel elle est incorporée, en imposant un état désiré à ce circuit.

A cet effet, la bascule comporte deux transistors suiveurs pour délivrer deux composantes de signal en sortie à partir de la sortie interne, et ces deux transistors suiveurs sont chacun l'un des transistors d'une paire dite de forçage dont la base de l'autre transistor est reliée à une entrée de signal de test.

De préférence, la base d'un transistor d'une paire de forçage étant reliée à l'une des connexions logiques constituant la sortie interne, le collecteur de l'autre transistor de la même paire est relié à l'autre connexion.

Cela permet d'obtenir deux états complémentaires sur les sorties.

La bascule comporte en outre avantageusement une entrée de commande qui est reliée aux bases d'une paire de transistors dits de commande dont les collecteurs sont reliés respectivement aux deux conducteurs du premier couple de connexions logiques, et les émetteurs des transistors de commande sont reliés ensemble au collecteur d'un transistor d'une paire de transistors dont les bases sont reliées aux connexions de sortie de la bascule.

Ceci permet d'inhiber le fonctionnement de la bascule sur demande.

Un circuit de pompe de charge, éventuellement inclus dans un circuit intégré, comporte avantageusement au moins une bascule selon l'invention.

Dans tout circuit intégré comportant une bascule selon le paragraphe introductif ci-dessus, cette bascule peut avantageusement être une bascule selon l'invention.

Ces aspects de l'invention ainsi que d'autres aspects plus détaillés apparaîtront plus clairement grâce à la description suivante d'un mode de réalisation constituant un exemple non limitatif.

La figure 1 est un schéma détaillé d'un mode de réalisation d'une bascule selon l'invention.

La figure 2 représente schématiquement une pompe de charge munie de bascules selon l'invention.

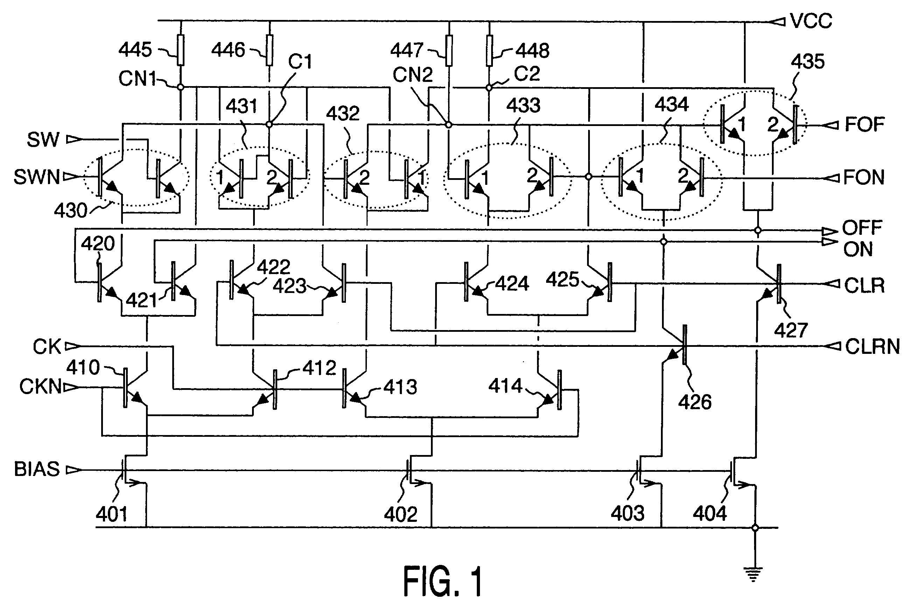

La bascule représentée par la figure 1 est réalisée à l'aide de portes CML différentielles. Elle est munie de deux transistors MOS 401 et 402, polarisés par une tension BIAS, et servant de résistances de queue pour deux paires 410/412 et 413/414, toutes deux commandées en entrée par un signal d'horloge symétrique CK/CKN. Le collecteur du transistor 412 alimente en courant une paire de transistors 422/423, commutés grâce à la connexion de leurs bases à un signal de définition d'état symétrique CLR/CLRN. Le collecteur du transistor 413 alimente en courant une paire 432, celui du transistor 414 alimente en courant une paire de transistors 424/425 également commutés grâce à la connexion de leurs bases au signal symétrique CLR/CLRN. Le collecteur du transistor 422 alimente en courant une paire 431. Le collecteur d'un premier transistor de la paire 431 et la base de l'autre transistor ainsi que la base d'un premier des transistors de la paire 432, sont connectés à une connexion CN1, reliée à l'alimentation VCC par une résistance 445. Le collecteur du second transistor et la base du premier transistor de la paire 431 ainsi que la base du second transistor de la paire 432, sont connectés à une connexion C1, reliée à l'alimentation VCC par une résistance 446. Le collecteur d'un premier des transistors et la base de l'autre transistor d'une paire 433 ainsi que le collecteur du premier transistor de la paire 432, sont connectés à une connexion C2, reliée à l'alimentation VCC par une résistance 448. Le collecteur du second transistor et la base du premier transistor de la paire 433 ainsi que le collecteur du second transistor de la paire 432, sont connectés à une connexion CN2, reliée à l'alimentation VCC par une résistance 447.

Le collecteur du transistor 423 est relié à la connexion C1, celui du transistor 424 alimente en courant la paire 433, et celui du transistor 425 est relié à la connexion C2. Ainsi, la bascule comporte une première paire de transistors 431 constituant une première demi-bascule, délivrant un premier signal logique sur un premier couple de connexions logiques C1, CN1, une seconde paire de transistors 433 constituant une seconde demi-bascule, délivrant un second signal logique sur un second couple de connexions logiques C2, CN2, les deux paires étant coupées entre elles au moyen d'une paire 432 pour constituer ensemble une bascule complète, et le second couple de connexions logiques C2, CN2 constituant une sortie interne du signal logique de la bascule en mode symétrique.

Deux transistors MOS 403, 404 sont polarisés par la tension BIAS. Lorsque la tension d'alimentation est inférieure à environ 3,5 volts, ces transistors servent de résistances de définition de courant pour des transistors 426,427 constituant des sources de courant et servant de résistances de queue pour une paire 434, et pour une paire 435. Les bases des transistors 426, 427 peuvent, comme c'est le cas ici, être reliées à la connexion CLR/CLRN, si la topographie du circuit rend cette connexion plus aisée, mais cette connexion ne joue aucun rôle fonctionne car la tension CLR, CLRN reste toujours telle que ces transistors restent conducteurs. A partir du schéma représenté, on pourrait aussi bien déconnecter les bases des transistors 426, 427 des entrées CLR/CLRN, et les relier ensemble, par exemple d'une part à l'alimentation VCC va deux diodes en série et d'autre part à la masse via une résistance.

Les transistors 434-1 et 435-1, fonctionnant en émetteurs suiveurs, fournissent les signaux de sortie ON et OFF, c'est-à-dire les deux composantes du signal de sortie, a partir de la sortie interne C2/CN2, et ces deux transistors suiveurs sont chacun l'un des transistors d'une paire dite de forçage dont la base de l'autre transistor respectivement 434-2 et 435-2 est reliée à une entrée de signal de test respectivement FON et FOF. La base du transistor 435-1 de la paire de transistors de forçage 435 étant reliée à la connexion logique CN2 constituant une demi-sortie interne, le collecteur de l'autre transistor 435-2 de la même paire 435 est relié à l'autre connexion C2. La réciproque s'applique mutatis mutandis à la paire 434.

On pourrait obtenir un forçage au moyen des connexions CLR/CLRN, mais alors les possibilités seraient réduites : on ne pourrait forcer qu'un seul état, et on ne pourrait agir que sur toutes les bascules à la fois, puisque la connexion CLR/CLRN est commune, alors qu'une action sur les paires 434, 435 permet toutes les combinaisons.

Les signaux FON et FOF sont normalement bas, et les seconds transistors des paires 434 et 435 sont coupés et ne modifient en rien le fonctionnement. En mode test, l'un ou l'autre de ces signaux est positionné à l'état actif, la sortie respective passe à l'état "1", quelque soit le positionnement de la bascule. Du fait que le collecteur du transistor 434-2 est relié à la connexion CN2, c'est-à-dire la sortie opposée par rapport à la sortie ON commandée par 434-1, le passage du courant à travers ce transistor impose une chute de tension dans la résistance 447, de telle façon que la sortie opposée est simultanément placée à l'état zéro. La réciproque s'applique mutatis mutandis à la paire 435. Tout ceci permet de vérifier différentes caractéristiques du circuit dans lequel est utilisé la bascule, en forçant certains éléments dans un état connu stable.

La bascule comporte en outre ici une entrée SW/SWN de commande qui est reliée aux bases d'une paire de transistors 430 dits de commande, dont les collecteurs sont reliés respectivement aux deux conducteurs C1 et CN1 du premier couple de connexions logiques. Les émetteurs de ces transistors 430 de commande sont reliés au collecteur d'un transistor 420 d'une paire de transistors 420/421, alimentée par le transistor 410, et dont les bases sont reliées aux connexions de sortie ON/OFF de la bascule. Le collecteur du transistor 421 est relié à la connexion CN1. Les portes 431, 432 exigent le pré-positionnement du signal SW/SWN : ce signal permet d'utiliser seulement un front de signal CK/CKN par période de comparaison, les autres n'étant pas acceptés. Le choix du front actif est dévolu à un compteur (extérieur au circuit) qui envoie une impulsion de sélection à l'entrée SW/SWN de la bascule. Ainsi la fréquence de comparaison est un sous-multiple de la fréquence d'un signal d'oscillateur appliqué à l'entrée CK/CKN. A partir de l'instant où la bascule est activée, l'état est maintenu pendant les cycles d'horloge suivants même si l'entrée SW est retombée, tant que l'entrée CLR/CLRN ne l'a pas remis à zéro.

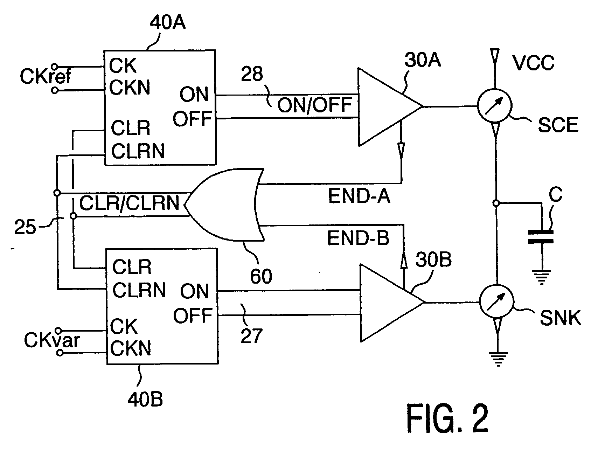

La figure 2 montre la structure d'ensemble d'une pompe de charge, branchée entre une alimentation VCC et la masse. Elle comporte un étage de sortie fait d'une source de courant de charge SCE, et d'une source de courant de décharge SNK. Les courants de ces deux sources SCE et SNK se retranchent l'un de l'autre dans une capacité C dont la charge représente la tension de sortie de la pompe. Un circuit de commande 30A, 30B est utilisé pour commander le courant dans chacune des sources respectivement SCE, SNK. Un signal symétrique Ckvar à comparer est amené à l'entrée d'horloge CK, CKN d'une bascule 40B conforme à celle de la figure 1, et un signal pilote symétrique Ckref est amené à une entrée CK, CKN d'une autre bascule 40A de même type. Ces bascules du genre D ne sont toutefois pas rigoureusement des bascules D : elles basculent sur une impulsion d'horloge CK/CKN, mais elles sont rétablies dans leur état initial par la commande asynchrone CLR/CLRN. La pulsation du courant de sortie de chacun des circuits de commande 30A, 30B est initiée par la sortie ON/OFF de chacune des bascules 40A, 40B. Lorsque le courant dans les deux sources SCE et SNK à la fois est établi, les circuits de commande 30A et 30B envoient toutes deux un signal respectivement END-A et END-B à une porte 60 de type OU, dont le signal de sortie CLR/CLRN est appliqué aux entrées CLR/CLRN des deux bascules à la fois, ce qui entraîne leur basculement au prochain signal d'horloge.

## Revendications

1. Bascule du genre D réalisable dans une technique dite ECL ou CML, comportant une première paire de transistors constituant une première demi-bascule, délivrant un premier signal logique sur un premier couple de connexions logiques, une seconde paire de transistors constituant une seconde demi-bascule, délivrant un second signal logique sur un second couple de connexions logiques, les deux paires étant couplées entre elles pour constituer ensemble une bascule complète, la seconde paire de connexions logiques constituant une sortie interne de signal logique de la bascule, en mode symétrique, **caractérisée en ce qu**'elle comporte deux transistors suiveurs pour délivrer deux composantes de signal en sortie à partir de la sortie interne, et ces deux transistors suiveurs sont chacun l'un des transistors d'une paire dite de forçage dont la base de l'autre transistor est reliée à une entrée de signal de test.

2. Bascule selon la revendication 1, **caractérisée en ce que**, la base d'un transistor d'une paire de forçage étant reliée à l'une des connexions logiques constituant la sortie interne, le collecteur de l'autre transistor de la même paire est relié à l'autre connexion.

3. Bascule selon l'une des revendications 1 ou 2, **caractérisée en ce qu**'elle comporte en outre une entrée de commande qui est reliée aux bases d'une paire de transistors dits de commande dont les collecteurs sont reliés respectivement aux deux conducteurs du premier couple de connexions logiques.

4. Bascule selon la revendication 3, **caractérisée en ce que** les émetteurs des transistors de commande sont reliés ensemble au collecteur d'un transistor d'une paire de transistors dont les bases sont reliées aux connexions de sortie de la bascule.

5. Circuit de pompe de charge, **caractérisé en ce qu**'il comporte au moins une bascule selon l'une quelconque des revendications 1 à 4.

6. Circuit intégré, **caractérisé en ce qu**'il comporte un circuit de pompe de charge selon la revendication 5.

7. Circuit intégré comportant une bascule, **caractérisé en ce que** cette dernière est une bascule selon l'une des revendications 1 à 4.
